# EUROPÄISCHE PATENTSCHRIFT

(11) **EP 1 831 989 B1**
(45) Veröffentlichungstag und Bekanntmachung des Hinweises auf die Patenterteilung: **20.08.2008**
(21) Anmeldenummer: 05821927.0
(22) Anmeldetag: 07.12.2005
(51) Int. Cl.: H03D 7/14

(54) **MISCHERSCHALTKREIS, EMPFANGSSCHALTKREIS, SENDESCHALTKREIS UND VERFAHREN ZUM BETREIBEN EINES MISCHERSCHALTKREISES**
MIXING CIRCUIT, CAPTURING CIRCUIT, EMITTING CIRCUIT AND METHOD FOR OPERATING A MIXING CIRCUIT
CIRCUIT MELANGEUR, CIRCUIT DE RECEPTION, CIRCUIT D'EMISSION ET PROCEDE POUR FAIRE FONCTIONNER UN CIRCUIT MELANGEUR

(30) Priorität: 08.12.2004 DE 102004059117
(43) Veröffentlichungstag der Anmeldung: 12.09.2007
(73) Patentinhaber: ATMEL Germany GmbH, 74072 Heilbronn (DE)
(72) Erfinder: KARTHAUS, Udo, 89079 Ulm (DE)
(74) Vertreter: Müller, Wolf-Christian
(86) Internationale Anmeldenummer: PCT/EP2005/013111
(87) Internationale Veröffentlichungsnummer: WO 2006/061204

(56) Entgegenhaltungen:
- EP-A- 1 292 018
- US-A- 4 590 433
- US-A1- 2002 013 137
- US-B1- 6 348 830
- US-B1- 6 480 046
- US-B1- 6 542 019

## Beschreibung

Die vorliegende Erfindung betrifft einen Mischerschaltkreis, einen Empfangsschaltkreis, einen Sendeschaltkreis und ein Verfahren zum Betreiben eines Mischerschaltkreises.

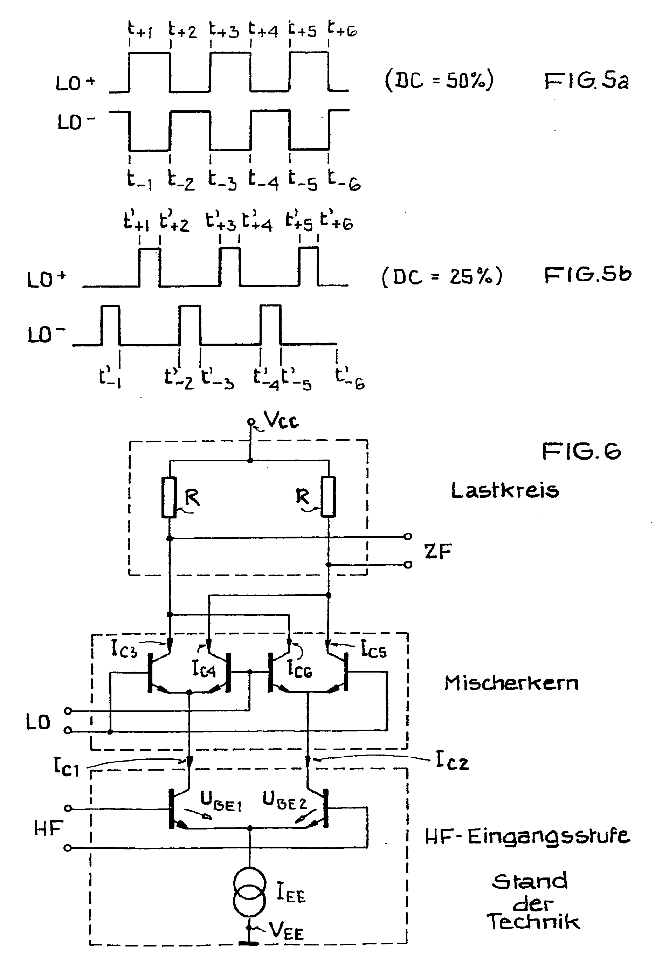

Aus der Dissertation "Monolithische Integration von Frequenzumsetzern bis 45 GHz in Silizium und SiGe", Seite 22ff., von Sabine Hackl, Februar 2002 an der Universität Wien, sind als Mischerschaltkreis unterschiedliche Arten der Gilbertzelle bekannt, wie diese beispielsweise in der Fig. 6 dargestellt ist.

Die Gilbertzelle gemäß Fig. 6 besteht aus einem Lastkreis (R), einem Mischerkern für den LO-Eingang und einer HF-Eingangsstufe. Die Eingangsstufen bestehen jeweils aus einem emittergekoppelten Transistorpaar. Betrachtet man die DC-Transferkennlinie dieses emittergekoppelten Transistorpaares im Großsignalverhalten, so wird die Funktion durch den tanh beschrieben. Der Mischerkern ist mit einem lokalen Oszillator (local oscillator) an seinem Eingang verbunden. Weiter *sind* der Mischerkern mit dem Lastkreis und die Emitter der NPN-Transistoren des Mischerkerns mit der HF-Eingangsstufe verbunden.

Je nach Ansteuerung der Eingangsstufen findet die Gilbertzelle als Mischer, Modulator, Demodulator, Multiplizierer oder Phasendetektor Verwendung.

Befinden sich die beiden Eingangsspannungen an den Eingängen HF und LO im linearen Bereich der Übertragungskennlinie, findet die Schaltung Verwendung als Multiplizierer. Dabei ist eine Optimierung auf hohe Linearität bzgl. beider Eingänge und eine hohe Ausgangsleistung erwünscht.

Für Mischer und Modulatoren liegen am HF-Eingang kleine Signale an, die im linearen Bereich der Kennlinie liegen, während der LO-Eingang Schaltsignale, die in der Begrenzung sind, aufnimmt. Die Schaltung wird bezüglich minimaler Rauschzahl und hoher Linearität bzgl. des HF-Eingangs optimiert. Legt man an beide Eingänge hohe Eingangsspannungen, die im Sättigungsbereich der Gesamt-Schaltung sind, so findet diese Schaltung Verwendung als Phasendetektor.

Die optimale Ansteuerung der LO-Eingangsstufe für Mischer und Modulatoren erfolgt durch Rechteck-Signale. In der Praxis stehen aber meist nur Sinus-Signale zur Verfügung, die Verluste mit sich bringen. Diese wirken sich im Vergleich zu Rechteck-Signalen in längere Umschaltzeiten zwischen zwei Zuständen aus, was wiederum zum Anstieg der Rauschzahl und zur Verringerung des Gewinns beiträgt. Um diese Verluste gering zu halten, ist eine hohe LO-Leistung notwendig. Eine Gewinneinbuße wird durch Sinus-Spannungen am LO-Eingang verursacht.

Das zu mischende Signal wird auf den differentiellen HF-Eingang der Gilbert-Zelle gegeben. Die "untere" Stromschalterstufe dient als Verstärker. In der "oberen" Stufe wird das Signal nun im Takt des LO-Signals zwischen den beiden Lastwiderständen hin- und hergeschaltet. (Hier ist eine Variante mit Bipolartransistoren als "Stromschalter" dargestellt.)

Man multipliziert also das zu mischende Signal mit einer Rechteckfunktion. Da man eine Rechteckfunktion auch als Summe von Sinusschwingungen der Grundfrequenz und den ungeraden Vielfachen davon darstellen kann, entspricht dieses Verfahren der multiplikativen Mischung mit dem Unterschied, dass in diesem Fall aufgrund der Oberwellen der Rechteckfunktion eine Filterung des Ausgangssignals vorgenommen werden sollte.

Ein verbesserter Mischerschaltkreis ist beispielsweise aus der US 6,542,019, *der* US 6,348,830 B1 *unter Verwendung von Bipolartransistoren oder der* US 6,480,046 B1 *unter Verwendung von Feldeffekttransistoren bekannt*. *Für eine geringe Stromaufnahme werden in der* US 4,590,433 *die Transistoren der zwei Differenzverstärker derart angesteuert, dass entweder alle vier Transistoren der zwei Differenzverstärker leiten oder jeweils nur ein Transistor eines Differenzverstärkers sperrt.*

Aufgabe der Erfindung ist es, einen Schaltkreis der eingangs genannten Art anzugeben, dessen Rauschen oder dessen Stromaufnahme möglichst reduziert und dessen Wirkungsgrad dabei möglichst verbessert ist.

Diese Aufgabe wird erfindungsgemäß durch einen Mischerschaltkreis mit den Merkmalen des Patentanspruchs 1, *mit den Merkmalen des Patentanspruchs 4* und einem Verfahren mit den Merkmalen des Patentanspruchs 15 gelöst. Vorteilhafte Weiterbildungen der Erfindung sind Gegenstand von Unteransprüchen.

Demgemäß ist ein Mischerschaltkreis vorgesehen, der einen Lastschaltkreis, eine Schwingkreis-Eingangsstufe, die mit einer ein Schwingungssignal abgebenden Schaltung (engl. auch local oscillator) verbunden ist und eine Signal-Eingangsstufe aufweist. *Die Schwingkreis-Eingangsstufe weist zumindest zwei Bipolartransistoren auf*, deren Emitter mit einem konstanten, von dem Schwingungssignal unabhängigen Potential, wie beispielsweise mit Masse oder mit einem Betriebspotential verbunden sind. Die Schwingkreis-Eingangsstufe mit den mindestens zwei Bipolartransistoren des Mischerschaltkreises ist dabei zum Schalten eines oder mehrerer Ströme des Mischerschaltkreises ausgebildet.

Eine derartige Beschaltung dieser beiden Bipolartransistoren ermöglicht einen Schaltbetrieb, der von dem Schwingungssignal, insbesondere von dessen Periode abhängig ist. Die, das Schwingungssignal abgebende Schaltung umfasst einen (lokalen) Oszillator mit vorzugsweise einem Schwingkreis, der vorteilhafterweise einen Quarz aufweist. Weiterhin kann diese, das Schwingungssignal abgebende Schaltung weitere Subschaltungen, wie beispielsweise einen Verstärker oder einen durchstimmbaren Filter aufweisen.

### Durch ein temporäres, zeitgleiches Sperren der zwei Transistoren wird erreicht, dass der Mischerschaltkreis temporär, insbesondere für eine kurze Zeit innerhalb einer Periode des Schwingungssignals, stromlos geschaltet wird.

Eine vorteilhafte Weiterbildung der Erfindung sieht vor, dass die Schwingkreis-Eingangsstufe derart ausgebildet ist, dass die zwei Bipolartransistoren in Abhängigkeit von dem Schwingungssignal temporär in der Sättigung betrieben werden. Das Schwingungssignal hat vorzugsweise eine konstante Frequenz, trägt selber keine Information, hat eine hinreichend große Amplitude und ist idealerweise rechteckig. Vorzugsweise werden die Bipolartransistoren durch dieses Schwingungssignal disjunkt eingeschaltet, so dass die zwei Bipolartransistoren nicht gleichzeitig eingeschaltet sind. In der Sättigung weisen diese Bipolartransistoren einen geringen Kollektor-Emitter-Widerstand auf. Vorteilhafterweise ist die Basis jedes Bipolartransistors mit einem Eingang des Mischerschaltkreises verbunden. Der Kollektor ist bevorzugt direkt mit der Signal-Eingangsstufe verbunden.

Eine bevorzugte Ausführungsform der Erfindung sieht vor, dass die Schwingkreis-Eingangsstufe aus genau zwei Bipolartransistoren oder genau zwei Bipolartransistorarrays besteht, wobei jedes Bipolartransistorarray ausschließlich parallel geschaltete Einzelbipolartransistoren aufweist, die zusammen wie ein Bipolartransistor wirken.

Ein anderer Aspekt der Erfindung ist ein Mischerschaltkreis mit einem Lastschaltkreis, einer Schwingkreis-Eingangsstufe, die mit einer ein Schwingungssignal abgebenden Schaltung verbunden ist, und einer Signal-Eingangsstufe. Dabei weist die Schwingkreis-Eingangsstufe zumindest zwei Feldeffekttransistoren auf, deren Source-Anschlüsse mit einem konstanten, von dem Schwingungssignal unabhängigen Potential, wie Masse oder dergleichen, verbunden sind. Die Schwingkreis-Eingangsstufe mit den mindestens zwei Feldeffekttransistoren des Mischerschaltkreises ist dabei zum Schalten eines oder mehrerer Ströme des Mischerschaltkreises ausgebildet.

### Durch ein temporäres, zeitgleiches Sperren der zwei Transistoren wird erreicht, dass der Mischerschaltkreis temporär, insbesondere für eine kurze Zeit innerhalb einer Periode des Schwingungssignals, stromlos geschaltet wird.

Um die Erfindung vorteilhaft weiterzubilden, ist die Schwingkreis-Eingangsstufe derart ausgebildet, dass die zwei Feldeffekttransistoren in Abhängigkeit von dem Schwingungssignal temporär im Widerstandsbereich betrieben werden. Vorzugsweise werden die Feldeffekttransistoren disjunkt eingeschalten, so dass die zwei Feldeffekttransistoren nicht gleichzeitig eingeschalten sind. In Widerstandbereich weisen diese Feldeffekttransistoren einen geringen Drain-Source-Widerstand auf. Vorteilhafterweise ist das Gate jedes Feldeffekttransistors mit einem Eingang des Mischerschaltkreises verbunden. Die Drain ist bevorzugt direkt mit der Signal-Eingangsstufe verbunden.

In einer bevorzugten Ausführungsform der Erfindung ist vorgesehen, dass die Schwingkreis-Eingangsstufe aus genau zwei Feldeffekttransistoren oder genau zwei Feldeffekttransistorarrays besteht, wobei jedes Feldeffekttransistorarray ausschließlich parallel geschaltete Einzelfeldeffekttransistoren aufweist, die zusammen wie ein Feldeffekttransistor wirken.

Eine besonders vorteilhafte Ausgestaltung der Erfindung sieht vor, dass die Signaleingangs-Stufe zumindest zwei Differenzverstärker aufweist, wobei jeder Differenzverstärker mit einem Transistor der Schwingkreis-Eingangsstufe, der ein Bipolartransistor oder ein Feldeffekttransistor sein kann, und einem Lastschaltkreis verbunden ist. Neben diesen Verbindungen können weitere Verbindungen der Signaleingangs-Stufe, beispielsweise zu Ausgängen der Schaltung vorgesehen sein. Vorteilhafterweise ist die Signal-Eingangsstufe als differenzielle Transkonduktanz-Stufe ausgebildet.

Bevorzugt weisen die Differenzverstärker eine Gegenkopplung, vorzugsweise eine Stromgegenkopplung auf. Vorteilhafte Ausgestaltungen einer Stromgegenkopplung sehen einen zusätzlichen Emitterwiderstand beziehungsweise einen zusätzlichen Source-Widerstand und/oder eine zusätzliche Induktivität und/oder eine zusätzliche Kapazität vor. Weiterhin kann auch ein gedämpfter Schwingkreis oder ein nichtlineares Bauelement als Stromgegenkopplung vorteilhaft sein.

Um die Transistoren in die Sättigung oder in den Widerstandsbereich möglichst schnell treiben zu können, ist in einer vorteilhaften Weiterbildung der Erfindung vorgesehen, dass die Schwingkreis-Eingangsstufe mit einem Treiber verbunden ist, der einen entsprechend niedrigen Ausgangswiderstand aufweist, um Eingangskapazitäten der Schwingkreis-Eingangsstufe schnell umzuladen.

Ein weiterer Aspekt der Erfindung ist ein Senderschaltkreis mit einem Mischerschaltkreis wie zuvor erläutert. Dabei ist die, das Schwingungssignal abgebende Schaltung zum zeitversetzten Einschalten der zwei Transistoren in Abhängigkeit von dem Schwingungssignal ausgebildet. Dem Mischerschaltkreis ist für den Sendebetrieb vorteilhafterweise ein Leistungsverstärker und auch ein Filter nachgeschaltet.

Besonders bevorzugt ist in einer Weiterbildung der Erfindung vorgesehen, dass die Schaltung zur Abgabe des Schwingungssignals zum temporären, zeitgleichen Sperren der zwei Transistoren der Schwingkreis-Eingangsstufe ausgebildet ist.

Ein anderer Aspekt der Erfindung ist ein Empfangsschaltkreis mit einem Mischerschaltkreis, so wie dieser zuvor erläutert wurde. Im Gegensatz zum Senderschaltkreis werden dem Mischerschaltkreis für den Empfangsbetrieb vorteilhafterweise differentielle Basisband- oder Zwischenfrequenzverstärker und/oder -filter nachgeschaltet.

Ein wiederum anderer Aspekt der Erfindung ist eine Verwendung dieses Mischerschaltkreises, dieses Empfangsschaltkreises oder dieses Senderschaltkreises in einer Basisstation oder einem Mobilfunkgerät eines zellulären Funknetzes, insbesondere in einem UMTS-Netz.

Weiterhin ist ein Aspekt der Erfindung ein Verfahren zum Betreiben eines Mischerschaltkreises, indem dem Mischerschaltkreis ein Schwingungssignal zugeführt wird, das Transistoren des Mischerschaltkreises temporär in der Sättigung und/oder in einem Widerstandsbereich betreibt. Dabei schaltet das Schwingungssignal den Mischerschaltkreis während des Herauf- oder Heruntermischens temporär stromlos.

Im Folgenden wird die Erfindung durch Ausführungsbeispiele anhand von zeichnerischen Darstellungen näher erläutert. Dabei zeigen:
- Fig. 1: eine Blockschaltbilddarstellung eines Mischerschaltkreises,
- Figuren 2a bis 2d: mehrere Ausführungsformen der Schalter S1 und S2 der Fig. 1,
- Figuren 3a bis 3c: mehrere Ausführungsformen von Differenzverstärkern für den Signal-Eingang DTS1 oder DTS2,
- Figuren 4a und 4b: zwei Ausführungsformen für den Lastkreis der Mischerschaltung und
- Figuren 5a und 5b: zwei Ausführungsformen möglicher Schwingungssignale.

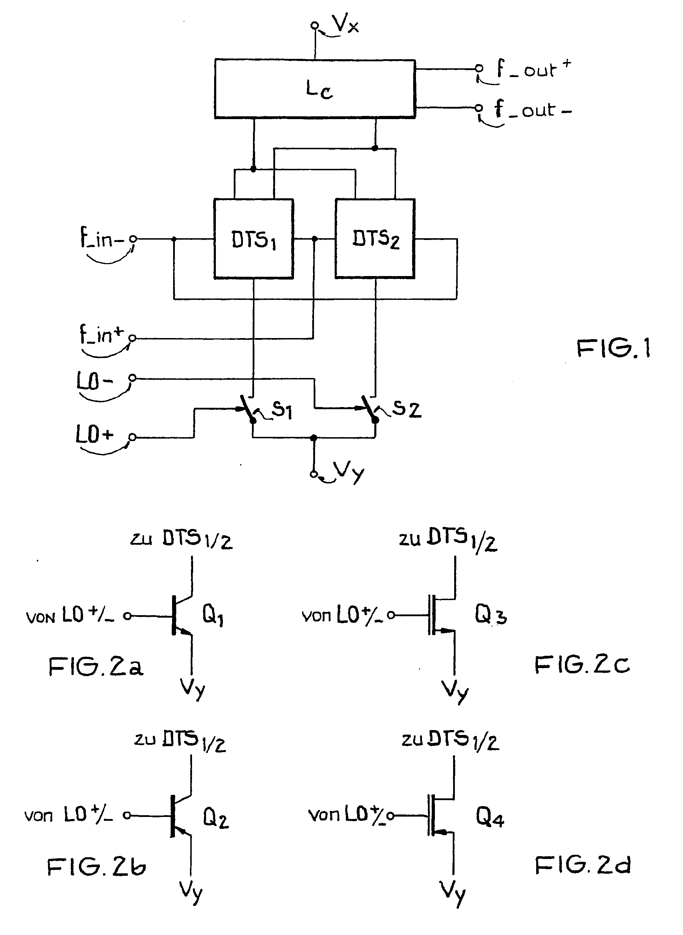

Das Blockschaltbild der Fig. 1 zeigt einen Mischerschaltkreis mit vier Eingängen (LO-, LO+, f_in-, f_in+), wobei zwei Eingänge LO- und LO+ einer Schwingungs-Eingangsstufe S1, S2 mit einem (lokalem) Oszillator (engl. local oscillator) verbunden sind, der für eine Anwendung in einem Sender und für eine Anwendung in einem Empfänger eine Trägerfrequenz oder eine von dieser Trägerfrequenz abweichende Frequenz (Zwischenfrequenz) zum Herauf- oder Heruntermischen erzeugt. Das Signal an diesen Eingängen LO-und LO+ hat eine konstante Frequenz, trägt selber keine Information, hat eine hinreichend große Amplitude und ist idealerweise rechteckig. Diese Eingänge LO- und LO+ sind jeweils mit einem als Schalter fungierenden Transistor S1 beziehungsweise S2 verbunden. Das an den Eingängen LO-und LO+ anliegende Schwingungssignal des Schwingkreises ist vorzugsweise in erster Näherung ein Rechtecksignal, dass die Schalter S1 und S2 schaltet.

Beispiele für die Schalter S1 und S2 sind in den Figuren 2a, 2b, 2c und 2d dargestellt. Dabei zeigt Fig. 2a einen NPN-Bipolartransistor Q1, wobei dessen Basis mit dem Eingang LO-/+ und dessen Emitter mit dem konstanten Spannungspotential Vy verbunden ist, das in diesem Fall beispielsweise Masse (GND) oder negative Spannungswerte (V_{EE}) annehmen kann. Der Kollektor ist mit einer Signal-Eingangsstufe DTS1 oder DTS2 verbunden.

Fig. 2b zeigt einen PNP-Bipolartransistor Q2, dessen Emitter wiederum mit dem konstanten Spannungspotential Vy verbunden ist. In diesem Fall ist Vy vorzugsweise positiv. Vorzugsweise werden Heterobipolartransistoren in SiGe-Technologie verwendet. Die Figuren 2c und 2d zeigen die entsprechend komplementären Verschaltungen für Feldeffekttransistoren Q3 und Q4 als Schalter S1 und S2. Geeignet sind hierbei sämtliche Bauarten eines Feldeffekttransistors, sowohl als selbst-sperrender als auch als selbstleitender Typ.

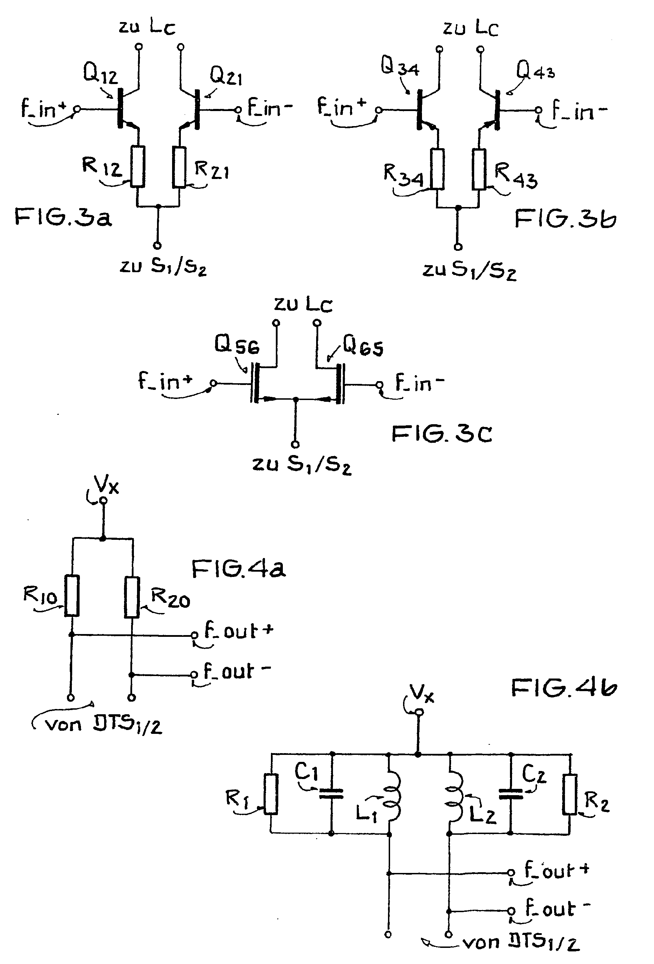

In der Fig. 1 sind die Signal-Eingänge f_in- und f_in+ mit der Signal-Eingangsstufe DTS1 und DTS2, die in diesem Ausführungsbeispiel aus zwei differenziellen Transkonduktanz-Stufen bestehen, verbunden. Für eine der differenziellen Transkonduktanz-Stufen DTS1 oder DTS2 kann dabei jede Art von Transistor (NMOS, PMOS, NPN, PNP) verwendet werden, wie dies beispielhaft in den Figuren 3a, 3b und 3c dargestellt ist.

Die Figuren 3a und 3b zeigen dabei zwei Ausführungsbeispiele mit Emitter-Gegenkopplung als Strom-Gegenkopplung. Die Gegenkopplung kann dabei - wie in den Figuren 3a und 3b dargestellt - durch einen Widerstand oder alternativ durch eine Induktivität oder einen Schwingkreis gebildet werden. Die differenziellen Transkonduktanz-Stufen DTS1 und DTS2 sind in dem Mischerschaltkreis sowohl mit jeweils einem Schalter S1 oder S2 als auch mit einem Lastkreis L_{C} verbunden. Ausführungsbeispiele des Lastkreises L_{C} sind in den Figuren 4a und 4b dargestellt. In Fig. 4a werden einfache Widerstände R10 und R20 und in Fig. 4b gedämpfte Schwingkreise aus den Bauelementen R1, C1, L1 beziehungsweise R2, C2 und L2 verwendet. Beispielsweise ist jeder Differenzverstärker DTS1 und DTS2 mit beiden, den Lastkreis L_{C} bildenden Widerständen R10 und R20 verbunden.

Das herauf- oder heruntergemischte Ausgangssignal steht gemäß Fig. 1 an den Ausgängen f_out- und f_out+ zur Verfügung. Dieses kann unter Verwendung von Filtern auf eine Antenne oder an einen Auswerteschaltkreis weitergeleitet werden.

In den LO-Transistoren S1 und S2 (Q1 oder Q2) fällt im eingeschalteten Zustand lediglich die Kollektor-Emitter-Spannung von beispielsweise 0,2 V ab, so dass gegenüber einer Gilbertzelle ein größerer Hub für die Eingangsspannungen und die Ausgangsspannung erzielt werden kann. Gleiches gilt für die Drain-Source-Spannung von beispielsweise 0,2 V für Feldeffekttransistoren.

Während der Schaltvorgänge der LO-Transistoren S1 und S2 tritt kein erhöhtes Rauschen auf. Das Rauschen, was die Transistoren S1 und S2 während der Schaltvorgänge produzieren, erscheint als Gleichtakt-Rauschen am Ausgang. Demzufolge ist die Rauschleistungsdichte des differenziellen Ausgangssignals nicht höher als bei einem Verstärker.

Weiterhin kann mit der Schaltung ein höherer Wirkungsgrad erzielt werden, wie dies anhand der Figuren 5a und 5b erläutert wird. Im Betrieb der Schaltung gemäß der Fig. 1 müssen die beiden Schalter nicht je 50% der Zeit eingeschaltet sein, so dass ständig ein Strom durch die Mischerschaltung fließt. Es ist auch ein kleineres Tastverhältnis DC von z.B. 10, 15, 20, 25 oder 30 % oder Zwischenwerte möglich. Ein Tastverhältnis von 25 % ist in der Fig. 5b dargestellt.

Während in der Fig. 5a die Schalter S1 und S2 wechselseitig ein- und ausgeschaltet werden, beträgt die Einschaltphase in der Fig. 5b jeweils nur 25%, so dass beispielsweise zwischen den Zeiten t'₋₁ bis t'₊₁, t'₊₂ bis t'₋₂ t'₋₃ bis t'₊₃, t'₊₄ bis t'₋₄ t'₋₅ bis t'₊₅ und t'₊₆ bis t'₋₆ kein Strom durch den Mischerschaltkreis fließt. Dies reduziert die Stromaufnahme daher um 50%, weil ja nur die Hälfte der Zeit Strom fließt. Der Grundwellenanteil des LO-Signals ist aber nur um den Faktor Wurzel aus zwei kleiner geworden. Damit ist auch das Ausgangssignal nur um den Faktor Wurzel aus zwei kleiner geworden. Der Wirkungsgrad hat sich also um den Faktor Wurzel aus zwei verbessert. Dies bewirkt für Mobilteile (UMTS) eine längere Akku-Lebensdauer und für Basisstation (UMTS) eine geringere Erwärmung des Halbleiterchips.

### Bezugszeichenliste

- R, R10, R20, R1, R2, R12, R21, R34, R43: Widerstand
- C1, C2: Kapazität, Kondensator
- L1, L2: Induktivität, Spule
- I_{C1}, I_{C2}, I_{C3}, I_{C4}, I_{C5}, I_{C6},: Kollektorstrom
- U_{BE1}, U_{BE2}: Basis-Emitter-Spannung
- LO: lokaler Oszillator
- LO-: negativer Eingang für das Oszillatorsignal
- LO+: positiver Eingang für das Oszillatorsignal
- HF: Signaleingang
- f_in-: negativer Signaleingang des Mischers
- f_in+: positiver Signaleingang des Mischers
- ZF: Ausgang
- f_out-: negativer Mischerausgang
- f_out+: positiver Mischerausgang
- V_{CC}: ositiver Spannungsversorgung
- V_{EE}: negative Spannungsversorgung
- I_{EE}: Stromsenke
- Vy, Vx: Spannungsversorgungsanschluss
- OTS₁, DTS₂: Differenzverstärker
- S1, S2: Halbleiterschalter, MOSFET, Bipolartransistor
- Q1, Q12, Q21: npn-Bipolartransistor
- Q2, Q34, Q43: pnp-Bipolartransistor
- Q3, Q56, Q65: NMOS-Transistor
- Q4: PMOS-Transistor
- DC: Tastverhältnis
- t₊₁, t₊₂, t₊₃, t₊₄, t₊₅, t₊₆, L₁, t₋₂, t₋₃, t₋₄,: Schaltzeitpunkte
- t₋₅, t₋₆, t'₋₁, t'₊₂, t'₊₃, t'₊₄, t'₊₅, t'₋₆,:
- t'₋₁, t'₋₂, t'₋₃, t'₋₄, t'₋₅, t'₋₆,:

## Patentansprüche

1. Mischerschaltkreis mit
- einem Lastschaltkreis (LC),
- einer Schwingkreis-Eingangsstufe (S1, S2), die mit einer, ein Schwingungssignal abgebenden Schaltung verbunden ist, *die in Abhängigkeit von diesem Schwingungssignal den Mischerschaltkreis temporär stromlos schaltet, und*
- einer Signal-Eingangsstufe (DTS1, DTS2),
wobei die Schwingkreis-Eingangsstufe (S1, S2) zumindest zwei *mit der das Schwingungssignal abgebenden Schaltung verbundene* Bipolartransistoren (Q1, Q2) aufweist, deren Emitter mit einem konstanten, von dem Schwingungssignal unabhängigen Potential (Vy) verbunden sind.

2. Mischerschaltkreis nach Anspruch 1,
**dadurch gekennzeichnet, dass**
die Schwingkreis-Eingangsstufe (S1, S2) derart ausgebildet ist, dass die Bipolartransistoren (Q1, Q2) in Abhängigkeit von dem Schwingungssignal temporär in der Sättigung betrieben werden.

3. Mischerschaltkreis nach einem der Ansprüche 1 oder 2,
**dadurch gekennzeichnet, dass**
die Schwingkreis-Eingangsstufe (S1, S2) aus genau zwei Bipolartransistoren (Q1, Q2) oder genau zwei Bipolartransistorarrays besteht, wobei jedes Bipolartransistorarray ausschließlich parallel geschaltete Einzelbipolartransistoren aufweist.

4. Mischerschaltkreis mit
- einem Lastschaltkreis (LC),
- einer Schwingkreis-Eingangsstufe (S1, S2), die mit einer ein Schwingungssignal abgebenden Schaltung verbunden ist, *die in Abhängigkeit von diesem Schwingungssignal den Mischerschaltkreis temporär stromlos schaltet,* und
- einer Signal-Eingangsstufe (DTS1, DTS2),
wobei die Schwingkreis-Eingangsstufe (S1, S2) zumindest zwei *mit der das Schwingungssignal abgebenden Schaltung verbundene* Feldeffekttransistoren (Q3, Q4) aufweist, deren Source-Anschlüsse mit einem konstanten, von dem Schwingungssignal unabhängigen Potential (Vy) verbunden sind.

5. Mischerschaltkreis nach Anspruch 4,
**dadurch gekennzeichnet, dass**
die Schwingkreis-Eingangsstufe (S1, S2) derart ausgebildet ist, dass die Feldeffekttransistoren (Q3, Q4) in Abhängigkeit von dem Schwingungssignal temporär im Widerstandsbereich betrieben werden.

6. Mischerschaltkreis nach einem der Ansprüche 4 oder 5,
**dadurch gekennzeichnet dass**
die Schwingkreis-Eingangsstufe (S1, S2) aus genau zwei Feldeffekttransistoren (Q3, Q4) oder genau zwei Feldeffekttransistorarrays besteht, wobei jedes Feldeffekttransistorarray ausschließlich parallel geschaltete Einzelfeldeffekttransistoren aufweist.

7. Mischerschaltkreis nach einem der vorhergehenden Ansprüche, **dadurch gekennzeichnet, dass** die Signal-Eingangsstufe (DTS1, DTS2) zumindest zwei Differenzverstärker aufweist, wobei jeder Differenzverstärker mit einem Transistor (Q1, Q2, Q3, Q4) der Schwingkreis-Eingangsstufe (S1, S2) und einem Lastschaltkreis verbunden ist.

8. Mischerschaltkreis nach Anspruch 7, **dadurch gekennzeichnet, dass** die Differenzverstärker eine Gegenkopplung, vorzugsweise eine Stromgegenkopplung aufweisen.

9. Mischerschaltkreis nach einem der vorhergehenden Ansprüche, **dadurch gekennzeichnet, dass** die Schwingkreis-Eingangsstufe (S1, S2) mit einem Treiber verbunden ist.

10. Senderschaltkreis mit einem Mischerschaltkreis nach einem der vorhergehenden Ansprüche, **dadurch gekennzeichnet, dass** die das Schwingungssignal abgebende Schaltung zum zeitversetzten Einschalten der zwei Transistoren (S1, S2, Q1, Q2, Q3, Q4) der Schwingkreis-Eingangsstufe in Abhängigkeit von dem Schwingungssignal ausgebildet ist.

11. Sendeschaltkreis nach Anspruch 10, **dadurch gekennzeichnet, dass** die Schaltung zur Abgabe des Schwingungssignals derart ausgebildet ist, dass temporär die Transistoren (S1, S2, Q1, Q2, Q3, Q4) der Schwingkreis-Eingangsstufe zeitgleich sperren.

12. Empfangsschaltkreis mit einem Mischerschaltkreis nach einem der vorhergehenden Ansprüche, **dadurch gekennzeichnet, dass** die das Schwingungssignal abgebende Schaltung zum zeitversetzten Einschalten der zwei Transistoren (S1, S2, Q1, Q2, Q3, Q4) der Schwingkreis-Eingangsstufe in Abhängigkeit von dem Schwingungssignal ausgebildet ist.

13. Empfangsschaltkreis nach Anspruch 12, **dadurch gekennzeichnet, dass** die Schaltung zur Abgabe des Schwingungssignals derart ausgebildet ist, dass temporär die Transistoren (S1, S2, Q1, Q2, Q3, Q4) der Schwingkreis-Eingangsstufe zeitgleich sperren.

14. Verwendung eines Mischerschaltkreises, eines Empfangsschaltkreises oder eines Senderschaltkreises nach einem der vorhergehenden Ansprüche in einer Basisstation oder einem Mobilfunkgerät eines zellulären Funknetzes.

15. Verfahren zum Betreiben eines Mischerschaltkreises *mit einem Lastschaltkreis (LC), einer Schwingkreis-Eingangsstufe (S1, S2) und einer Signaleingangsstufe (DTS1, DTS2),* indem *eine mit der Schwingkreis-Eingangsstufe (S1, S2) verbundene Schaltung* ein Schwingungssignal *abgibt, das* den Mischerschaltkreis temporär stromlos schaltet.

16. Verfahren nach Anspruch 15, **dadurch gekennzeichnet, dass** das *Schwingungssignal Transistoren (S1, S2, Q1, Q2, Q3, Q4) des Mischerschaltkreises temporär in der Sättigung und*/*oder im Widerstandsbereich betreibt*.

## Claims

1. Mixer circuit comprising
- a load circuit (LC),
- an oscillator circuit input stage (S1, S2) connected with a circuit which issues an oscillation signal and which switches the mixer circuit to be temporarily free of current in dependence on this oscillation signal, and
- a signal input stage (DTS1, DTS2),
wherein the oscillator circuit input stage (S1, S2) comprises at least two bipolar transistors (Q1, Q2), which are connected with the circuit issuing the oscillation signal and the emitters of which are connected with a constant potential (Vy) independent of the oscillation signal.

2. Mixer circuit according to claim 1, **characterised in that** the oscillator circuit input stage (S1, S2) is constructed in such a manner that the bipolar transistors (Q1, Q2) are operated temporarily in saturation in dependence on the oscillation signal.

3. Mixer circuit according to one of claims 1 and 2, **characterised in that** the oscillator circuit input stage (S1, S2) consists of exactly two bipolar transistors (Q1, Q2) or exactly two bipolar transistor arrays, wherein each bipolar transistor array has individual bipolar transistors connected exclusively in parallel.

4. Mixer circuit comprising
- a load circuit (LC),
- an oscillator circuit input stage (S1, S2) connected with a circuit which issues an oscillation signal and which switches the mixer circuit to be temporarily free of current in dependence on this oscillation signal, and
- a signal input stage (DTS1, DTS2),
wherein the oscillator circuit input stage (S1, S2) comprises at least two field effect transistors (Q3, Q4) which are connected with the circuit issuing the oscillation signal and the source connections of which are connected with a constant potential (Vy) independent of the oscillation signal.

5. Mixer circuit according to claim 4, **characterised in that** the oscillator circuit input stage (S1, S2) is constructed in such a manner that the field effect transistors (Q3, Q4) are operated temporarily in the resistance range in dependence on the oscillation signal.

6. Mixer circuit according to one of claims 4 and 5, **characterised in that** the oscillator circuit input stage (S1, S2) consists of exactly two field effect transistors (Q3, Q4) or exactly two field effect transistor arrays, wherein each field effect transistor array comprises individual field effect transistors connected exclusively in parallel.

7. Mixer circuit according to any one of the preceding claims, **characterised in that** the signal input stage (DTS1, DTS2) comprises at least two differential amplifiers, wherein each differential amplifier is connected with a transistor (Q1, Q2, Q3, Q4) of the oscillator circuit input stage (S1, S2) and a load circuit.

8. Mixer circuit according to claim 7, **characterised in that** the differential amplifiers have a negative feedback, preferably a negative current feedback.

9. Mixer circuit according to any one of the preceding claims, **characterised in that** the oscillator circuit input stage (S1, S2) is connected with a driver.

10. Transmitter circuit with a mixer circuit according to any one of the preceding claims, **characterised in that** the circuit issuing the oscillation signal is constructed for switching on the two transistors (S1, S2, Q1, Q2, Q3, Q4) of the oscillator input stage offset in time in dependence on the oscillation signal.

11. Transmitter circuit according to claim 10, **characterised in that** the circuit for issue of the oscillation signal is constructed in such a manner that the transistors (S1, S2, Q1, Q2, Q3, Q4) simultaneously temporarily block the oscillator circuit input stage.

12. Receiving circuit with a mixer circuit according to any one of the preceding claims, **characterised in that** the circuit issuing the oscillation signal is constructed for switching on the two transistors (S1, S2, Q1, Q2, Q3, Q4) of the oscillator input stage offset in time in dependence on the oscillation signal.

13. Receiving circuit according to claim 12, **characterised in that** the circuit for issue of the oscillation signal is constructed in such a manner that the transistors (S1, S2, Q1, Q2, Q3, Q4) simultaneously temporarily block the oscillator circuit input stage.

14. Use of a mixer circuit, a receiving circuit or transmitting circuit according to any one of the preceding claims in a base station or a mobile radio apparatus of a cellular radio network.

15. Method of operating a mixer circuit with a load circuit (LC), an oscillator circuit input stage (S1, S2) and a signal input stage (DTS1, DTS2), in that a circuit connected with the oscillator input stage (S1, S2) issues an oscillation signal which temporarily switches the mixer circuit to be free of current.

16. Method according to claim 15, **characterised in that** the oscillation signal temporarily operates the transistors (S1, S2, Q1, Q2, Q3, Q4) of the mixer circuit in saturation and/or in the resistance range.

## Revendications

1. Circuit mélangeur comprenant
- un circuit à coupure en charge (LC),
- un étage d'entrée de circuit oscillant (S1, S2) relié à un circuit émettant un signal oscillant, qui commute le circuit mélangeur temporairement dans un état sans courant en fonction de ce signal oscillant, et
- un étage d'entrée de signal (DTS1, DTS2),
dans lequel l'étage d'entrée du circuit oscillant (S1, S2) présente au moins deux transistors bipolaires (Q1, Q2) reliés au circuit émettant le signal oscillant, dont les émetteurs sont reliés à un potentiel (Vy) constant, indépendant du signal oscillant.

2. Circuit mélangeur selon la revendication 1, **caractérisé en ce que** l'étage d'entrée du circuit oscillant (S1, S2) est conçu de telle façon que les transistors bipolaires (Q1, Q2) sont temporairement saturés en fonction du signal oscillant.

3. Circuit mélangeur selon l'une quelconque des revendications 1 ou 2, **caractérisé en ce que** l'étage d'entrée du circuit oscillant (S1, S2) consiste exactement en deux transistors bipolaires (Q1, Q2) ou exactement en deux groupements de transistors bipolaires, chaque groupement de transistors bipolaires présentant exclusivement des transistors bipolaires individuels montés en parallèle.

4. Circuit mélangeur comprenant
- un circuit à coupure en charge (LC),
- un étage d'entrée du circuit oscillant (S1, S2) relié à un circuit émettant un signal oscillant, qui commute le circuit mélangeur temporairement dans un état sans courant en fonction de ce signal oscillant, et
- un étage d'entrée de signal (DTS1, DTS2),
dans lequel l'étage d'entrée du circuit oscillant (S1, S2) présente au moins deux transistors à effet de champ (Q3, Q4) reliés au circuit émettant le signal oscillant, dont les connexions-sources sont reliées à un potentiel (Vy) constant, indépendant du signal oscillant.

5. Circuit mélangeur selon la revendication 4, **caractérisé en ce que** l'étage d'entrée du circuit oscillant (S1, S2) est conçu de telle façon que les transistors à effet de champ (Q3, Q4) sont utilisés temporairement dans la zone de résistance en fonction du signal oscillant.

6. Circuit mélangeur selon l'une quelconque des revendications 4 ou 5, **caractérisé en ce que** l'étage d'entrée du circuit oscillant (S1, S2) consiste en exactement deux transistors à effet de champ (Q3, Q4) ou exactement deux groupements de transistors à effet de champ, chaque groupement de transistors à effet de champ présentant exclusivement des transistors à effet de champ individuels montés en parallèle.

7. Circuit mélangeur selon l'une quelconque des revendications précédentes, **caractérisé en ce que** l'étage d'entrée de signal (DTS1, DTS2) présente au moins deux amplificateurs différentiels, chaque amplificateur différentiel étant relié à un transistor (Q1, Q2, Q3, Q4) de l'étage d'entrée du circuit oscillant (S1, S2) et un circuit à coupure en charge.

8. Circuit mélangeur selon la revendication 7, **caractérisé en ce que** l'amplificateur différentiel présente une rétroaction, de préférence une rétroaction de courant.

9. Circuit mélangeur selon l'une quelconque des revendications précédentes, **caractérisé en ce que** l'étage d'entrée du circuit oscillant (S1, S2) est relié à un pilote.

10. Circuit émetteur comprenant un circuit mélangeur selon l'une quelconque des revendications précédentes, **caractérisé en ce que** le circuit émettant le signal oscillant est conçu pour une mise en service décalée dans le temps des deux transistors (S1, S2, Q1, Q2, Q3, Q4) de l'étage d'entrée du circuit oscillant en fonction du signal oscillant.

11. Circuit émetteur selon la revendication 10, **caractérisé en ce que** le circuit d'émission du signal oscillant est conçu de telle façon que temporairement, les transistors (S1, S2, Q1, Q2, Q3, Q4) de l'étage d'entrée du circuit oscillant sont bloqués.

12. Circuit récepteur comprenant un circuit mélangeur selon l'une quelconque des revendications précédentes, **caractérisé en ce que** le circuit émettant le signal oscillant est conçu pour une mise en service décalée dans le temps des deux transistors (S1, S2, Q1, Q2, Q3, Q4) de l'étage d'entrée du circuit oscillant en fonction du signal oscillant.

13. Circuit récepteur selon la revendication 12, **caractérisé en ce que** le circuit est conçu de telle façon pour l'émission du signal oscillant que temporairement, les transistors (S1, S2, Q1, Q2, Q3, Q4) de l'étage d'entrée du circuit oscillant sont bloqués.

14. Utilisation d'un circuit mélangeur, d'un circuit récepteur ou d'un circuit émetteur selon l'une quelconque des revendications précédentes dans une station de base ou un émetteur-récepteur mobile d'un réseau radio cellulaire.

15. Procédé d'utilisation d'un circuit mélangeur comprenant un circuit à coupure en charge (LC), un étage d'entrée du circuit oscillant (S1, S2) et un étage d'entrée de signal (DTS1, DTS2) dans lequel un circuit relié à l'étage d'entrée du circuit oscillant (S1, S2) émet un signal oscillant, qui commute le circuit mélangeur temporairement dans un état sans courant.

16. Procédé selon la revendication 15, **caractérisé en ce que** le signal oscillant fait passer temporairement des transistors (S1, S2, Q1, Q2, Q3, Q4) du circuit mélangeur dans un état saturé et/ou dans la zone de résistance.
